# EUROPÄISCHE PATENTSCHRIFT

(11) **EP 1 728 414 B1**
(45) Veröffentlichungstag und Bekanntmachung des Hinweises auf die Patenterteilung: **05.09.2007**
(21) Anmeldenummer: 05728234.5
(22) Anmeldetag: 10.03.2005
(51) Int. Cl.: H05K 1/18

(54) **ANORDNUNG MIT EINEM ELEKTROMOTOR UND EINER HAUPTLEITERPLATTE UND MONTAGEVERFAHREN**
DEVICE PROVIDED WITH AN ELECTRIC MOTOR AND A MAIN PRINTED CIRCUIT BOARD AND MOUNTING METHOD
DISPOSITIF COMPRENANT UN MOTEUR ELECTRIQUE ET UNE CARTE DE CIRCUITS IMPRIMES PRINCIPALE ET PROCEDE DE MONTAGE

(30) Priorität: 23.03.2004 DE 102004014137
(43) Veröffentlichungstag der Anmeldung: 06.12.2006
(73) Patentinhaber: SIEMENS AKTIENGESELLSCHAFT, 80333 München (DE)
(72) Erfinder: WAHLER, Torsten, 78073 Bad Dürrheim (DE); WOLF, Peter, 78078 Niedereschach (DE); HAUTVAST, Heinz-Josef, 78086 Brigachtal (DE)
(86) Internationale Anmeldenummer: PCT/EP2005/051069
(87) Internationale Veröffentlichungsnummer: WO 2005/094145

(56) Entgegenhaltungen:
- US-A- 4 931 679
- US-A- 5 658 165
- PATENT ABSTRACTS OF JAPAN Bd. 1999, Nr. 12, 29. Oktober 1999 (1999-10-29) & JP 11 204912 A (CANON INC), 30. Juli 1999 (1999-07-30)

## Beschreibung

Die Erfindung betrifft eine Anordnung mit einem Elektromotor und einer Hauptleiterplatte mit Kontaktstellen, welcher Elektromotor ein Gehäuse und mit den Kontaktstellen in einer elektrisch leitenden Verbindung stehende Anschlusskontakte aufweist, welches Gehäuse eine erste Stirnseite und eine dieser gegenüberliegende zweite Stirnseite aufweist, welche Anschlusskontakte im Bereich der zweiten Stirnseite an dem Gehäuse angeordnet sind, wobei der Elektromotor derart zur Hauptleiterplatte angeordnet ist, dass die zweite Stirnseite von der Hauptleiterplatte fort weist. Die elektrisch leitende Verbindung ist dabei mindestens für Drehmomente, die in einer Richtung senkrecht zur Längserstreckung der elektrisch leitenden Verbindung orientiert sind, biegesteif ausgebildet. Daneben ist ein Montageverfahren für eine derartige Anordnung Gegenstand der Erfindung.

Aus der US 4,931,679 ist eine Anordnung mit einem Elektromotor und einer mit Kontaktstellen versehenen Leiterplatte bekannt, bei der der Elektromotor auf beiden Stirnseiten Anschlusskontakte aufweist. Dabei ist ein Anschlusskontakt der einen Stirnseite jeweils mit einem Anschlusskontakt der anderen Stirnseite über im Inneren des Motorgehäuses verlaufende elektrische Leitungen verbunden.

Die US 5,658,165 offenbart eine Steckverbindung zur elektrischen Verbindung von elektrischen Bauteilen mit einer flexiblen Leiterplatte. Dafür ist an einem elektrischen Bauteil ein männliches Steckverbinderteil vorgesehen, welches mit einem auf der flexiblen Leiterplatte befindlichen weiblichen Steckverbinderteil verbindbar ist. In dem weiblichen Steckverbinderteil ist ein von der flexiblen Leiterplatte abzweigendes und mit Leiterbahnen versehenes Streifenstück eingeklemmt.

Eine weitere Möglichkeit zur Verbindung eines elektrischen Bauteils mit einer flexiblen Leiterplatte wird in Patent Abstracts of Japan, Publication No. 11204912, beschrieben.

Herkömmliche Anordnungen weisen zahlreiche Nachteile auf, insbesondere hinsichtlich des Aufwandes der Montage und der Funktionsprüfung. Üblicherweise werden für die elektrische Verbindung der Anschlusskontakte mit den Kontaktstellen Kabel verwendet, die mittels Steckverbindungen an den Kontaktstellen und den Anschlusskontakten leitend angebracht werden oder zumindest an einer der beiden Verbindungspunkte zu verlöten sind. Häufig sind die Elektromotore in Öffnungen oder Ausnehmungen anzuordnen, wobei bereits angebrachte Kabel die Einbringbewegung führend durch diese Öffnungen hindurchgefädelt werden müssen. Aufgrund der unvorhersehbaren Position der Kabel mangels Formstabilität müssen derartige Montageschritte manuell erfolgen. Hierbei kann es dennoch passieren, dass der Vorgang des Einfädelns fehlerhaft erfolgt und zumindest ein Kabel zwischen dem Elektromotor und der Ausnehmungskontur eingeklemmt wird. Daneben erfordert das Herstellen der leitenden Verbindung mittels der Steckkontakte einen ganzen Arbeitsschritt durch das Montagepersonal. Eine Funktionsprüfung macht zur Bestromung ein Lösen der Steckkontakte erforderlich. Das Erfordernis des Steckens der Steckkontakte eröffnet außerdem das Fehlerrisiko, dass dieser Montageschritt schlicht vergessen wird, was eine aufwändige Demontage zur Folge hat.

Ausgehend von den Problemen und Nachteilen des Stands der Technik liegt der Erfindung die Aufgabe zugrunde, den Aufwand der Serienmontage der eingangs genannten Anordnung kostengünstig zu reduzieren.

Die erfindungsgemäße Lösung sieht eine Anordnung der eingangs beschriebenen Art vor mit den Merkmalen den kennzeichnenden Teils des Anspruchs 1. Gegenstand der Unteransprüche sind zweckmäßige Weiterbildungen der Erfindung.

Die biegesteife Ausbildung der elektrisch leitenden Verbindung mindestens für Drehmomente, die in einer Richtung senkrecht zur Längserstreckung der Verbindung orientiert sind, hat zur Folge, dass sich die Montage des Elektromotors mit den umgebenden Komponenten entscheidend vereinfacht. Die Formstabilität erleichtert dem Montagepersonal ein etwaiges Einfädeln der Verbindung in Ausnehmungen, da sich dieses Bauelement vorhersehbarer verhält. Der Umgang mit der elektrisch leitenden Verbindung, beispielsweise zum Kontaktieren, kann gleichsam blind erfolgen, da sie sich nicht an unerwarteter Stelle befinden kann. Daneben ist das Risiko, dass während des Betriebes nicht mechanische Störungen aufgrund eines Positionswechsels der elektrisch leitenden Verbindung verursacht werden, wegen der Formstabilität stark reduziert.

Zur Vermeidung von Steckkontakten und den damit verbundenen, eingangs beschriebenen Nachteilen ist es zweckmäßig, wenn die Kontaktstellen als Federkontakt ausgebildet sind und die elektrisch leitende Verbindung mittels eines relativ zu dem Elektromotor befestigten Formstücks an die Federkontakte elektrisch leitend anpressbar ist. Auf diese Weise kann eine elektrische Kontaktierung bereits zwingend korrekt und unvergessbar aufgrund des Zusammenfügens der Hauptleiterplatte mit dem Elektromotor erfolgen. Das Formstück kann hierbei eine als erfindungsgemäße leitende Verbindung eingesetzte flexible Leiterplatte versteifend unterstützen oder Teil des zuvor beschriebenen Kunststoffspritzgusselements sein.

Eine besonders zweckmäßige erfindungsgemäße Weiterbildung sieht vor, dass die elektrische Verbindung aus mindestens einer flexiblen Leiterplatte besteht. Diese Ausbildung ist kostengünstig und erfüllt die aufgabengemäßen Anforderungen.

Eine andere Variante sieht vor, dass die elektrisch leitende Verbindung von einem Kunststoffspritzgusselement versteifend umgeben ist. Hierbei können metallische Kontaktbleche unter Verwendung der Inserttechnik umspritzt werden, wobei die elektrische Verbindung in dem Kunststoffspritzgusselement vorzugsweise mäanderförmig verlaufen kann, um eine Beschädigung der Verbindung infolge von Relativdehnungen der beiden Materialien zueinander zu vermeiden.

Mit Vorteil kann das Kunststoffspritzgusselement den Elektromotor zumindest teilweise umgeben, so dass der Elektromotor in einem Hohlraum zwischen der Hauptleiterplatte und dem Kunststoffspritzgusselement gehalten ist. Auf diese Weise erfüllt die Versteifung der elektrisch leitenden Verbindung mittels des Kunststoffspritzgusselements nicht nur die Funktion einer Montagevereinfachung sondern zusätzlich wird der Elektromotor geschützt und gehaltert. Hierzu kann das Kunststoffspritzgusselement zweckmäßig mit federnden Rasthaken versehen sein, mittels derer es an der Hauptleiterplatte einfach befestigt werden kann.

Besonders sinnvoll ist die erfindungsgemäße Anordnung, wenn eine Antriebswelle des Elektromotors sich senkrecht zur Hauptleiterplatte erstreckt und aus der ersten Stirnseite des Gehäuses des Elektromotors herausragt. Bei einer solchen Anordnung ergibt sich nämlich regelmäßig ein großer zu überbrückender Abstand zwischen den Kontaktstellen der Hauptleiterplatte und den Anschlusskontakten des Elektromotors, der mittels der elektrisch leitenden Verbindung zu überbrücken ist.

Insbesondere für den Einsatz im Kraftfahrzeug ist es zweckmäßig, wenn die elektrisch leitende Verbindung im Bereich der leitenden Kontaktierung zu den Federkontakten von einem Schutzgehäuse zumindest teilweise umgeben ist, welches an der Hauptleiterplatte abdichtend anliegt. Dieses Schutzgehäuse kann mit Vorteil einstückig mit dem zuvor beschriebenen Formstück bzw. dem Kunststoffspritzgusselement ausgebildet sein. Eine weitere Reduzierung des Fertigungsaufwandes ergibt sich, wenn die Federkontakte als SMD-Bauteile ausgebildet sind.

Zur Gewährleistung einer stets reproduzierbaren, sicheren Lage der elektrisch leitenden Verbindung im Falle der Ausbildung als flexible Leiterplatte ist es zweckmäßig, wenn die flexible Leiterplatte mittels Klebung an dem Gehäuse befestigt ist. Eine andere zweckmäßige Variante der Fixierung der flexiblen Leiterplatte sieht eine Befestigung mittels federnder Rasthaken an dem Gehäuse und/oder dem Formstück vor.

Die vorstehend beschriebene erfindungsgemäße Vorrichtung mit ihren zweckmäßigen Weiterbildungen ist unterstützt besonders ein Montageverfahren, bei dem in einem ersten Schritt auf einem Grundträger ein Elektromotor in einer Montagerichtung aufgesetzt wird, in einem zweiten Schritt eine Hauptleiterplatte, welche eine Ausnehmung für den Elektromotor aufweist, im Wesentlichen parallel zu dem Grundträger in einer Endposition angeordnet wird, wobei die Hauptleiterplatte mit Kontaktstellen versehen ist, welche mit Anschlusskontakten des Elektromotors beim Erreichen der Endposition in eine elektrisch leitende Verbindung treten.

Die vorbeschriebene Anordnung mit ihren zweckmäßigen Weiterbildungen findet besonders vorteilhafte Anwendung für einen Chipkarteneinzug eines digitalen Tachographen in einem Kraftfahrzeug, da dort besondere Anforderungen an den Bauraum, die Stabilität und die Montagefreundlichkeit, insbesondere hinsichtlich der extremen thermischen und mechanischen Randbedingungen gestellt werden.

Zur Verdeutlichung der Erfindung ist in der Folge ein spezielles Ausführungsbeispiel unter Bezugnahme auf Zeichnungen näher beschreiben. Es zeigen:
- Fig. 1:: eine flexible Leiterplatte in der Draufsicht,
- Fig. 2:: eine perspektivische Darstellung einer Hauptleiterplatte,
- Fig. 3:: eine perspektivische, teilweise Darstellung einer erfindungsgemäßen Anordnung mit einem Elektromotor und einer flexiblen Leiterplatte,
- Fig. 4:: eine perspektivische Darstellung einer erfindungsgemäßen Anordnung mit einem Elektromotor, einer flexiblen Leiterplatte, einem Formstück und einem Grundträger,
- Fig. 5:: eine perspektivische Darstellung einer erfindungsgemäßen Anordnung mit einem Elektromotor, einer flexiblen Leiterplatte, einem Grundträger und einer Hauptleiterplatte,
- Fig. 6:: ein Schnitt durch ein Kunststoffspritzgusselement mit einer erfindungsgemäßen elektrisch leitenden Verbindung,
- Fig. 7:: eine perspektivische Darstellung einer erfindungsgemäßen Anordnung mit einem Elektromotor, einem Kunststoffspritzgusselement, einem Grundträger und einer angedeuteten Hauptleiterplatte.

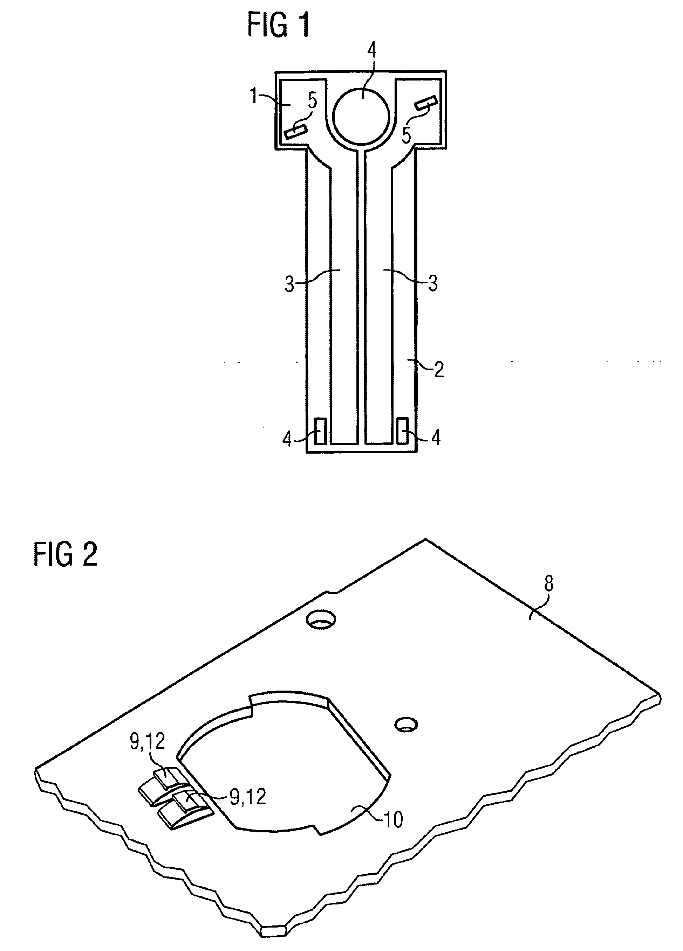

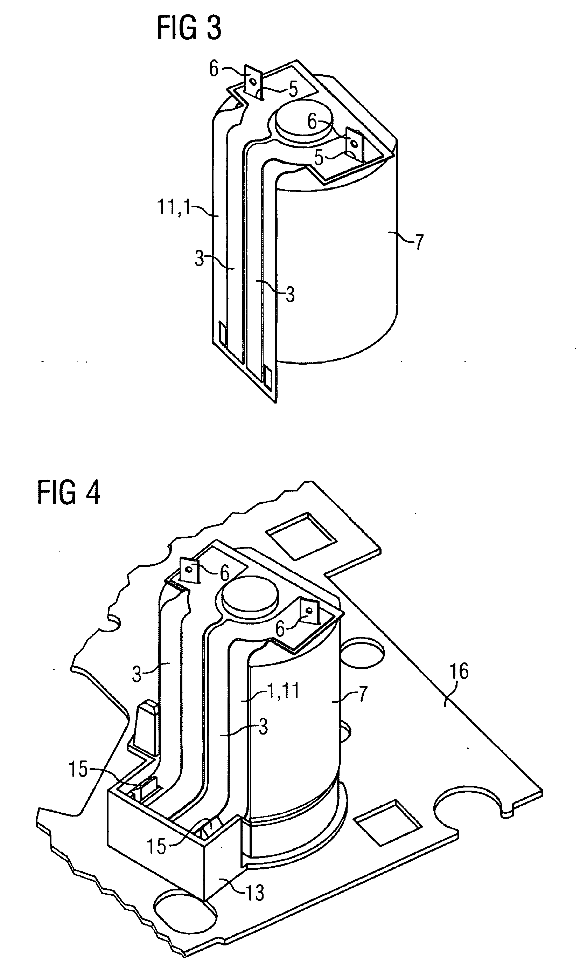

In der Darstellung der Fig. 1 ist eine flexible Leiterplatte mit dem Bezugszeichen 1 versehen und besteht im Wesentlichen aus einem nicht leitenden Trägermaterial 2 und zwei voneinander getrennt leitenden Leiterbahnen 3. Das Trägermaterial 2 ist mit drei Ausnehmungen 4 versehen, die der Befestigung der flexiblen Leiterplatte 1 dienen und die beiden Leiterbahnen 3 weisen jeweils eine Durchstecköffnung 5 für jeweils einen Anschlusskontakt 6 eines beispielsweise in Fig. 3 dargestellten Elektromotors 7 auf.

Eine in Fig. 2 dargestellte Hauptleiterplatte 8 ist neben anderen nicht dargestellten Bauelementen mit zwei Federkontakten 9 bestückt, mit welchem eine elektrisch leitende Verbindung 10, beispielsweise die flexible Leiterplatte 1 der Fig. 1 bei der Montage in Kontakt tritt. Benachbart zu den Federkontakten 9 ist die Hauptleiterplatte 8 mit einer Ausnehmung 10 versehen, in welche beispielsweise der in Fig. 3 dargestellte Elektromotor 7 einsetzbar ist.

In Fig. 3 ist die Zusammenstellung von Elektromotor 7 mit einer elektrisch leitenden Verbindung 11, ausgebildet als flexible Leiterplatte 1 gemäß Fig. 1 dargestellt. Die Anschlusskontakte 6 des Elektromotors 7 sind als Blechstreifen ausgebildet und durch die Durchstecköffnungen 5 der Leiterbahnen 3 hindurchgeführt.

Fig. 4 zeigt die weiterführende erfindungsgemäße Kombination der Elemente der Fig. 3 mit einem Grundträger 16 unter Verwendung eines Formstücks 13, mittels welchem die elektrisch leitende Verbindung 11 an die nicht sichtbar dargestellten, als Federkontakte 9 ausgebildeten Kontaktstellen 12 angedrückt werden. Die elektrisch leitende Verbindung 11 ist an dem Formstück 13 mittels Rasthaken 15 befestigt, so dass die korrekte Position der Leiterbahnen 3 stets gewährleistet ist.

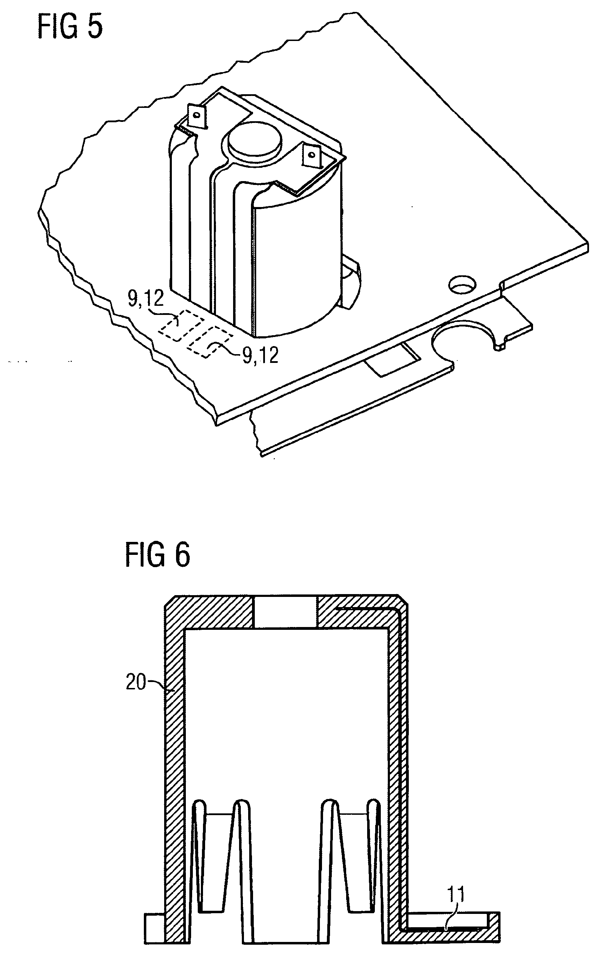

Fig. 5 zeigt die Kombination der in Fig. 4 dargestellten Elemente mit der Hauptleiterplatte 8, wobei aus dieser Perspektive eigentlich unsichtbar und daher gestrichelt dargestellte Federkontakte 9 auf der Unterseite der Hauptleiterplatte 8 mit den Leiterbahnen 3 der flexiblen Leiterplatte 1 in Verbindung treten.

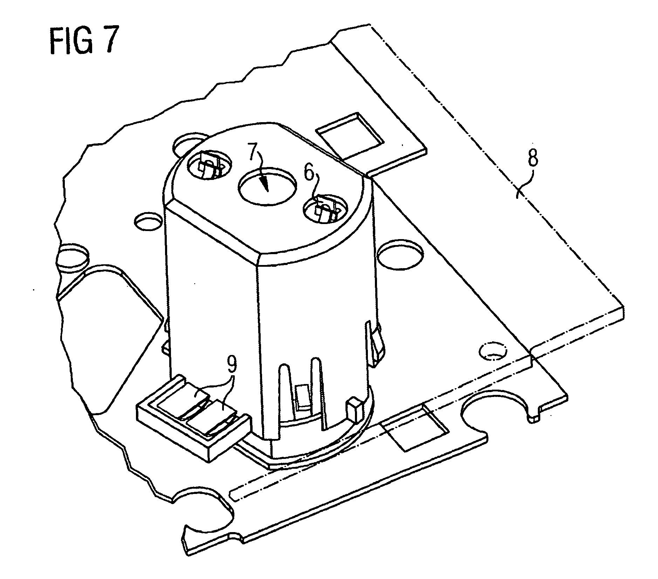

In Fig. 6 ist ein Kunststoffspritzgusselement mit einer im Insertverfahren eingebetteten elektrisch leitenden Verbindung 11 dargestellt. Die elektrisch leitende Verbindung 11 ist hierbei als eingespritztes Kontaktblech 21 ausgeführt und weist isolationsfreie Flächen in den Bereichen auf, in denen es gemäß der Darstellung in Fig. 7 mit den Anschlusskontakten 6 des Elektromotors 7 und den Federkontakten 9 eine elektrisch leitende Verbindung eingeht. Das Kunststoffspritzgusselement 20 bildet vergleichsweise ein Außengehäuse für den Elektromotor 7, der einseitig der Leiterplatte nahezu vollständig von selbigem umgeben ist. Auf diese Weise wird sowohl eine elektrische Leitung zwischen der elektrisch leitenden Verbindung 11 und den Anschlusskontakten 6 des Elektromotors 7 erreicht und eine elektrische Leitung zwischen der elektrisch leitenden Verbindung 11 und den Federkontakten 9 als auch der Elektromotor 7 an der Hauptleiterplatte 8 befestigt. Die Befestigung an der Hauptleiterplatte 8 erfolgt mittels Rasthaken 23.

## Patentansprüche

1. Anordnung mit einem Elektromotor (7) und einer Hauptleiterplatte (8) mit Kontaktstellen (12),
- welcher Elektromotor (7) ein Gehäuse und mit den Kontaktstellen (12) in einer elektrisch leitenden Verbindung (11) stehende Anschlusskontakte (6) aufweist,
- welches Gehäuse eine erste Stirnseite und eine dieser gegenüberliegende zweite Stirnseite aufweist,
- welche Anschlusskontakte (6) im Bereich der zweiten Stirnseite an dem Gehäuse angeordnet sind, wobei der Elektromotor (7) derart zur Hauptleiterplatte (8) angeordnet ist, dass die zweite Stirnseite von der Hauptleiterplatte (8) fort weist,
- welche elektrisch leitende Verbindung (11) mindestens für Drehmomente, die in einer Richtung senkrecht zur Längserstreckung der elektrisch leitenden Verbindung (11) orientiert sind, biegesteif ausgebildet ist,
**dadurch gekennzeichnet, dass**,
- die Hauptleiterplatte(8) eine Ausnehmung aufweist, in welcher der Elektromotor (7) angeordnet ist,
- die Kontaktstellen (12) der Hauptleiterplatte (8) als Federkontakte (9) ausgebildet und auf der Unterseite der Hauptleiterplatte (8) angeordnet sind und
- die elektrisch leitende Verbindung (11) an einem Formstück (13) befestigt ist, mittels welchem die elektrisch leitende Verbindung (11) an die Federkontakte (9) elektrisch leitend angedrückt wird.

2. Anordnung nach Anspruch 1, **dadurch gekennzeichnet, dass** die elektrische Verbindung (11) aus mindestens einer flexiblen Leiterplatte (1) besteht.

3. Anordnung nach Anspruch 1, **dadurch gekennzeichnet, dass** die elektrische leitende Verbindung (11) von einem Kunststoffspritzgusselement (20) versteifend umgeben ist.

4. Anordnung nach Anspruch 3, **dadurch gekennzeichnet, dass** die elektrische Verbindung (11) in dem Kunststoffspritzgusselement (20) meanderförmig verläuft.

5. Anordnung nach Anspruch 3, **dadurch gekennzeichnet, dass** das Kunststoffspritzgusselement (20) den Elektromotor (7) zumindest teilweise derart umgibt, dass der Elektromotor (7) in einem Hohlraum zwischen der Hauptleiterplatte (8)und dem Kunststoffspritzgusselement (20) gehalten ist.

6. Anordnung nach Anspruch 3, **dadurch gekennzeichnet, dass** das Kunststoffspritzgusselement (20) federnde Rasthaken (15) aufweist, mittels derer es an der Hauptleiterplatte (8) befestigt ist.

7. Anordnung nach Anspruch 1, **dadurch gekennzeichnet, dass** eine Antriebswelle des Elektromotors (7) senkrecht zur Hauptleiterplatte (8) orientiert ist und aus der ersten Stirnseite herausragt,

8. Anordnung nach Anspruch 1, **dadurch gekennzeichnet, dass** die elektrisch leitende Verbindung (11) im Bereich der leitenden Kontaktierung zu den Federkontakten (9) von einem Schutzgehäuse zumindest teilweise umgeben ist, welches an der Hauptleiterplatte (8) abdichtend anliegt.

9. Anordnung nach Anspruch 8, **dadurch gekennzeichnet, dass** die Federkontakte (9) als SMD-Bauelemente ausgebildet sind.

10. Anordnung nach Anspruch 2, **dadurch gekennzeichnet, dass** die flexible Leiterplatte (1) mittels Klebung an dem Gehäuse befestigt ist.

11. Anordnung nach Anspruch 2, **dadurch gekennzeichnet, dass** die flexible Leiterplatte (1) mittels federnder Rasthaken (23) an dem Gehäuse und/oder dem Formstück (13) befestigt ist.

12. Verfahren zur Montage einer Anordnung gemäß mindestens einem der vorstehenden Ansprüche, wobei
- in einem ersten Schritt auf einem Grundträger (16) ein Elektromotor (7) in einer Montagerichtung aufgesetzt wird,
- in einem zweiten Schritt eine Hauptleiterplatte (8), welche eine Ausnehmung für den Elektromotor (7) aufweist, im Wesentlichen parallel zu dem Grundträger (16) in einer Endposition angeordnet wird, so dass der Elektromotor (7) in der Hauptleiterplatte (8) angeordnet ist,
- wobei die Hauptleiterplatte (8) an ihrer Unterseite mit als Federkontakte (9) ausgebildeten Kontaktstellen (12) versehen ist, welche mit Anschlusskontakten (6) des Elektromotors (7) beim Erreichen der Endposition in eine elektrisch verbunden werden, indem eine mit den Anschlusskontakten (6) verbundene elektrisch leitende Verbindung (11) mittels eines Formstücks (13) an die Kontaktstellen (12) elektrisch leitend angedrückt wird.

## Claims

1. Arrangement having an electric motor (7) and a main printed circuit board (8) with contact points (12),
- which electric motor (7) has a housing and connecting contacts (6) which are electrically conductively connected (11) to the contact points (12),
- which housing has a first end face and a second end face opposite it,
- which connecting contacts (6) are arranged in the area of the second end face on the housing, with the electric motor (7) being arranged with respect to the main printed circuit board (8) in such a manner that the second end face faces away from the main printed circuit board (8),
- which electrically conductive connection (11) is resistant to bending, at least for torques which are oriented in a direction at right angles to the longitudinal extent of the electrically conductive connection (11),
**characterized in that**
- the main printed circuit board (8) has a recess in which the electric motor (7) is arranged,
- the contact points (12) of the main printed circuit board (8) are in the form of spring contacts (9) and are arranged on the lower face of the main printed circuit board (8) and
- the electrically conductive connection (11) is secured to a moulding (13), by means of which the electrically conductive connection (11) is pressed in an electrically conductive manner against the spring contacts (9).

2. Arrangement according to Claim 1, **characterized in that** the electrical connection (11) comprises at least one flexible printed circuit (1).

3. Arrangement according to Claim 1, **characterized in that** the electrically conductive connection (11) is surrounded by a plastic injection-moulded element (20), in order to stiffen it.

4. Arrangement according to Claim 3, **characterized in that** the electrical connection (11) runs in a meandering shape in the plastic injection-moulded element (20).

5. Arrangement according to Claim 3, **characterized in that** the plastic injection-moulded element (20) at least partially surrounds the electric motor (7) in such a manner that the electric motor (7) is held in a cavity between the main printed circuit board (8) and the plastic injection-moulded element (20).

6. Arrangement according to Claim 3, **characterized in that** the plastic injection-moulded element (20) has sprung latching hooks (15), by means of which it is attached to the main printed circuit board (8).

7. Arrangement according to Claim 1, **characterized in that** a drive shaft of the electric motor (7) is oriented at right angles to the main printed circuit board (8), and projects out of the first end face.

8. Arrangement according to Claim 1, **characterized in that** the electrically conductive connection (11) is at least partially surrounded in the area of the conductive contact with the spring contacts (9) by a protective housing, which rests on the main printed circuit board (8), forming a seal.

9. Arrangement according to Claim 8, **characterized in that** the spring contacts (9) are in the form of SMD components.

10. Arrangement according to Claim 2, **characterized in that** the flexible printed circuit (1) is attached to the housing by means of adhesive bonding.

11. Arrangement according to Claim 2, **characterized in that** the flexible printed circuit (1) is attached to the housing and/or to the moulding (13) by means of sprung latching hooks (23).

12. Method for assembly of an arrangement according to at least one of the preceding claims, with
- an electric motor (7) being placed on a base mount (16) in an installation direction in a first step,
- a main printed circuit board (8), which has a recess for the electric motor (7), being arranged essentially parallel to the base mount (16) in a final position in a second step, so that the electric motor (7) is arranged in the main printed circuit board (8),
- with the main printed circuit board (8) being provided on its lower face with contact points (12) in the form of spring contacts (9) which make an electrical connection with connecting contacts (6) on the electric motor (7) on reaching the final position since an electrically conductive connection (11) connected to the connecting contacts (6) is pressed in an electrically conductive manner against the contact points (12) by means of a moulding (13).

## Revendications

1. Dispositif comportant un moteur électrique (7) et une carte principale à circuits imprimés (8) comportant des points de contact (12),
- ledit moteur électrique (7) ayant un boîtier et des contacts de raccordement (6) assurant une liaison électrique (11) avec les points de contact (12),
- ledit boîtier ayant une première face frontale et une deuxième face frontale sur le côté opposé à la première face frontale,
- lesdits contacts de raccordement (6) étant disposés dans la zone de la deuxième face frontale et le moteur électrique (7) étant disposé par rapport à la carte principale à circuits imprimés (8) de telle manière que la deuxième face frontale est tournée du côté opposé à la carte principale à circuits imprimés (8),
- ledit organe de liaison électrique (11) étant rigide à la flexion au moins pour des couples de rotation orientés dans une direction perpendiculaire à la dimension principale de l'organe de liaison électrique (11),
**caractérisé par le fait que**
- la carte principale à circuits imprimés (8) comporte un évidement dans lequel est disposé le moteur électrique (7),
- les points de contact (12) de la carte principale à circuits imprimés (8) sont conçus sous la forme de contacts à ressort (9) et sont disposés sur la face inférieure de la carte principale à circuits imprimés (8) et
- l'organe de liaison électrique (11) est fixé à une pièce usinée (13) au moyen de laquelle l'organe de liaison électrique (11) est appliqué, établissant ainsi une conduction électrique, sur les contacts à ressort (9).

2. Dispositif selon la revendication 1, **caractérisé par le fait que** l'organe de liaison électrique (11) se compose de au moins une carte à circuits imprimés souple (1).

3. Dispositif selon la revendication 1, **caractérisé par le fait que** l'organe de liaison électrique (11) est entouré en le rendant rigide par un élément (20) en matière plastique moulé par injection.

4. Dispositif selon la revendication 3, **caractérisé par le fait que** l'organe de liaison électrique (11) est disposé en forme de méandre dans l'élément (20) en matière plastique moulé par injection.

5. Dispositif selon la revendication 3, **caractérisé par le fait que** l'élément (20) en matière plastique moulé par injection entoure au moins partiellement le moteur électrique (7) de telle manière que le moteur électrique (7) est maintenu dans un espace creux entre la carte principale à circuits imprimés (8) et l'élément (20) en matière plastique moulé par injection.

6. Dispositif selon la revendication 3, **caractérisé par le fait que** l'élément (20) en matière plastique moulé par injection comporte des crochets d'arrêts élastiques (15) au moyen desquels il est fixé à la carte principale à circuits imprimés (8).

7. Dispositif selon la revendication 1, **caractérisé par le fait qu'**un arbre d'entraînement du moteur électrique (7) est orienté perpendiculairement à la carte principale à circuits imprimés (8) et fait saillie hors de la première face frontale.

8. Dispositif selon la revendication 1, **caractérisé par le fait que** l'organe de liaison électrique (11) est au moins partiellement entouré, dans la zone de la mise en conduction électrique avec les contacts de raccordement (9), par un boîtier de protection qui s'applique d'une façon étanche sur la carte principale à circuits imprimés (8).

9. Dispositif selon la revendication 8, **caractérisé par le fait que** les contacts à ressort (9) sont conçus sous la forme de composants SMD ou composants montés en surface.

10. Dispositif selon la revendication 2, **caractérisé par le fait que** la carte à circuits imprimés souple (1) est fixée au boîtier au moyen d'un assemblage collé.

11. Dispositif selon la revendication 2, **caractérisé par le fait que** la carte à circuits imprimés souple (1) est fixée au boîtier et/ou à la pièce usinée (13) au moyen de crochets d'arrêts élastiques (23).

12. Procédé permettant le montage d'un dispositif selon au moins l'une des revendications précédentes, au cours duquel,
- dans une première phase, un moteur électrique (7) est placé sur un support de base (16) dans une direction de montage,
- dans une deuxième phase, une carte principale à circuits imprimés (8), qui comporte un évidement pour le moteur électrique (7), est disposée, pour l'essentiel, parallèlement au support de base (16) dans une position finale, si bien que le moteur électrique (7) est placé dans la carte principale à circuits imprimés (8),
- la carte principale à circuits imprimés (8) étant pourvue, sur sa face inférieure de points de contact (12) conçus sous la forme de contacts à ressort (9), lesquels, lorsque la position finale est atteinte, sont mis en conduction électrique avec des contacts de raccordement (6) du moteur électrique (7) par le fait qu'un organe de liaison électrique (11) relié aux contacts de raccordement (6) est appliqué, établissant ainsi une conduction électrique, contre les points de contact (12) au moyen d'une pièce usinée.
